# FASCICULE DE BREVET EUROPEEN

(11) **EP 3 754 353 B1**
(45) Date de publication et mention de la délivrance du brevet: **09.08.2023**
(21) Numéro de dépôt: 20180413.5
(22) Date de dépôt: 17.06.2020
(51) Int. Cl.: G01R 31/367, G01R 31/3842, G01R 31/3828

(54) **PROCÉDÉ DE DÉTERMINATION D'UN ESTIMATEUR ROBUSTE DE LA CAPACITÉ D'UNE BATTERIE ÉLECTRIQUE**
VERFAHREN ZUR BESTIMMUNG EINES ROBUSTEN SCHÄTZERS DER KAPAZITÄT EINER ELEKTRISCHEN BATTERIE
METHOD FOR DETERMINING A ROBUST ESTIMATOR OF THE CAPACITY OF AN ELECTRIC BATTERY

(30) Priorité: 20.06.2019 FR 1906645
(43) Date de publication de la demande: 23.12.2020
(73) Titulaire: Commissariat à l'Energie Atomique et aux Energies Alternatives, 75015 Paris (FR)
(72) Inventeur: MICHEL, Paul-Henri, 38054 GRENOBLE CEDEX 9 (FR); HEIRIES, Vincent, 38054 GRENOBLE CEDEX 9 (FR)
(74) Mandataire: Cabinet Beaumont

(56) Documents cités:
- WO-A1-2017/142586
- US-A1- 2019 036 356
- FARMANN ALEXANDER ET AL: "Critical review of on-board capacity estimation techniques for lithium-ion batteries in electric and hybrid electric vehicles", JOURNAL OF POWER SOURCES, ELSEVIER SA, CH, vol. 281, 22 janvier 2015 (2015-01-22), pages 114-130, XP029142623, ISSN: 0378-7753, DOI: 10.1016/J.JPOWSOUR.2015.01.129

## Description

### Domaine technique

La présente description concerne de façon générale le domaine des batteries électriques, et vise plus particulièrement un procédé de détermination de la capacité d'une batterie ou d'une cellule élémentaire d'une batterie.

### Technique antérieure

Une batterie électrique est un groupement de plusieurs cellules élémentaires rechargeables (piles, accumulateurs, etc.) reliées en série et/ou en parallèle entre deux bornes principales de fourniture de tension.

Une batterie est souvent associée à un dispositif de gestion relié aux bornes des cellules élémentaires de la batterie et/ou aux bornes principales de la batterie, qui peut mettre en oeuvre des fonctions diverses telles que des fonctions d'équilibrage des cellules, des fonctions de protection, etc.

Dans certains systèmes, le dispositif de gestion gère des jauges ou indicateurs lui permettant d'estimer à tout instant l'état de charge, aussi appelé SOC (de l'anglais "State of Charge") de chaque cellule élémentaire de la batterie et/ou l'état de charge de la batterie complète. Par état de charge, on entend ici le rapport entre la charge contenue dans la cellule ou dans la batterie, et la capacité totale de la cellule ou de la batterie à l'instant considéré. Le dispositif de gestion peut par exemple estimer l'état de charge de chaque cellule à partir d'algorithmes prédéfinis et/ou de mesures réalisées par des capteurs reliés aux cellules de la batterie.

Dans certains systèmes, le dispositif de gestion gère en outre un indicateur complémentaire représentatif de la capacité des cellules et/ou de la batterie complète. La connaissance de la capacité de chaque cellule et/ou de la batterie complète peut par exemple permettre d'identifier des cellules défectueuses pour les isoler ou les remplacer, d'anticiper la fin de vie de la batterie pour la remplacer, et/ou de recaler ou réajuster les jauges d'état de charge des cellules ou de la batterie pour tenir compte de leur vieillissement, de façon à leur permettre de continuer à fournir une estimation fiable.

Par souci de simplification, dans la suite de la description, on utilisera le terme batterie pour désigner indifféremment une cellule élémentaire de batterie ou une batterie complète, étant entendu que les procédés d'estimation de capacité décrits peuvent être appliqués soit à chaque cellule élémentaire de la batterie soit à la batterie complète.

La capacité d'une batterie est une grandeur non mesurable directement. Elle est la résultante de diverses propriétés liées aux caractéristiques électrochimiques de la batterie, et dépend notamment des conditions d'utilisation de cette dernière.

Pour mesurer la capacité d'une batterie la batterie peut être complètement déchargée puis complètement rechargée, ou complètement rechargée puis complètement déchargée. Lors de la phase de recharge complète ou de décharge complète, la charge accumulée dans la batterie ou extraite de la batterie peut être mesurée par comptage coulométrique, c'est-à-dire par intégration du courant injecté dans la batterie ou extrait de la batterie, ce qui revient à mesurer la capacité réelle de la batterie. Un inconvénient de cette technique est qu'elle nécessite la mise en oeuvre d'une décharge complète suivie d'une charge complète, ou d'une charge complète suivie d'une décharge complète, ce qui est contraignant et ne peut en pratique pas être réitéré suffisamment régulièrement pour pouvoir disposer à tout moment d'une estimation fiable de la capacité de la batterie.

D'autres méthodes d'estimation de la capacité d'une batterie à partir de mesures partielles en charge ou en décharge, ont été proposées dans la littérature. Ces méthodes sont toutefois soit non robustes, soit dépendantes d'une base d'apprentissage souvent difficile à obtenir pour chaque référence de cellule élémentaire susceptible d'être utilisée dans une batterie.

A titre d'exemple, l'article intitulé "Recursive approximate weighted total least squares estimation of battery cell total capacity" (G.L.Plett, Journal of Power Sources, 2010) décrit une méthode d'estimation basée sur la méthode de moindres carrés totaux, à partir de mesures de courant et d'état de charge. Cette méthode n'est toutefois pas robuste en cas de points de mesure aberrants, ce qui arrive fréquemment dans la mesure où l'état de charge est une variable estimée, affectée par plusieurs sources d'erreur (biais, bruits, etc.)

L'article intitulé "On-board state of health monitoring of lithium-ion batteries using incremental capacity analysis with support vector régression" (C. Weng et al, Journal of Power Sources, 2013) décrit quant à lui une méthode d'apprentissage automatique, qui nécessite une base d'apprentissage complète. Il faut donc pouvoir disposer de données mesurées lors de cycles complets de charge et décharge de batteries dans toutes les conditions d'utilisation et à différents niveaux de vieillissement. L'acquisition d'une telle base de données est longue et coûteuse.

L'article intitulé "Incremental capacity Analysis and close-to-equilibrium OCV measurements to quantify capacity fade in commercial rechargeable lithium batteries" (M. Dubarry et al, ECS, 2006) décrit une méthode d'analyse de la capacité incrémentale. Il s'agit d'une méthode précise mais qui nécessite des signaux calibrés et normés, et d'attendre des points d'équilibre sur la tension de la batterie. Cette méthode ne peut ainsi pas être appliquée à partir des données mesurées lors d'une utilisation normale de la batterie.

Les documents US2019/036356 et WO2017/142586 décrivent des exemples de procédé d'estimation de paramètres d'une batterie.

Il serait souhaitable de pouvoir disposer d'une méthode d'estimation de la capacité d'une batterie électrique, palliant tout ou partie des inconvénients des méthodes connues.

### Résumé de l'invention

Un mode de réalisation prévoit un procédé d'estimation de la capacité d'une batterie électrique, mis en oeuvre par un dispositif électronique de gestion de la batterie, comportant les étapes suivantes :
a) lors d'une phase de recharge et/ou de décharge de la batterie, sélectionner une pluralité de périodes de mesure et, pour chaque période, mesurer la variation de charge ΔQ et estimer la variation d'état de charge ΔSOC de la batterie entre le début et la fin de la période de mesure ; et
b) estimer la capacité de la batterie au moyen d'un filtre de Kalman à partir des valeurs ΔQ et ΔSOC déterminées à l'étape a),

dans lequel l'étape b) comprend en outre une étape de détermination ou d'approximation de l'ordonnée à l'origine d'une droite approximant un nuage de points défini par l'ensemble des couples de valeurs ΔQ, ΔSOC acquis à l'étape a),
dans lequel l'étape b) comprend en outre une étape 203-3 de sélection, dans le nuage de points, d'un sous-ensemble de points qui satisfont un critère de consensus ou critère de réjection des points aberrant, ledit sous-ensemble de points (401) étant déterminé par une méthode de consensus par sélection aléatoire d'échantillon unique comprenant N_{hyp} itérations successives de la séquence d'étapes suivantes, où N_{hyp} est un entier supérieur ou égal à 2 :
   203-3a) sélection aléatoire d'un unique point non déjà sélectionné dans le nuage de points ;
   203-3b) détermination d'une droite passant par le point sélectionné à l'étape 203-3a) et par l'ordonnée à l'origine déterminée ou approximée ; et
   203-c) détermination des points du nuage qui satisfont le critère de consensus par rapport à la droite déterminée à l'étape 203-3b),
   et dans lequel l'étape b) comprend en outre une étape 203-4 de mise à jour du filtre de Kalman à partir du sous-ensemble de points (401) sélectionné à l'étape 203-3.

Selon un mode de réalisation, à l'étape a), les périodes de mesure sont sélectionnées de façon que la densité de probabilité de sélection des valeurs de variation de charge ΔQ suive une loi normale tronquée.

Selon un mode de réalisation, les étapes a) et b) sont réitérées de façon régulière au cours de l'utilisation de la batterie.

Selon un mode de réalisation, le nombre de périodes de mesure sélectionnées à chaque itération de l'étape a), et par conséquent le nombre de couples de valeurs ΔQ, ΔSOC acquis à chaque itération de l'étape a), est compris entre 10 et 100.

Selon un mode de réalisation, l'étape b) comprend une étape 203-1 de prédiction de la capacité de la batterie à partir d'un modèle d'état de l'évolution de la capacité, ce modèle constituant une équation de prédiction du filtre de Kalman.

Selon un mode de réalisation, à l'étape 203-2, la droite et l'ordonnée à l'origine sont déterminées en appliquant au nuage de points une transformée de Hough à résolution adaptative.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente de façon schématique un exemple d'un système comportant une batterie électrique et un dispositif électronique de gestion adapté à mettre en oeuvre un procédé d'estimation de la capacité de la batterie ;
la figure 2 représente de façon schématique, sous forme de blocs, un mode de réalisation d'un procédé d'estimation de la capacité d'une batterie ;
la figure 3 est un diagramme illustrant le fonctionnement du procédé de la figure 2 ; et
la figure 4 est un autre diagramme illustrant le fonctionnement du procédé de la figure 2.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la réalisation d'un dispositif électronique de gestion adapté à mettre en oeuvre les procédés d'estimation de capacité décrits n'a pas été détaillée, la réalisation d'un tel dispositif étant à la portée de l'homme du métier à partir des indications fonctionnelles de la présente description.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Sauf précision contraire, les expressions "environ", "approximativement", "sensiblement", et "de l'ordre de" signifient à 10 % près, de préférence à 5 % près.

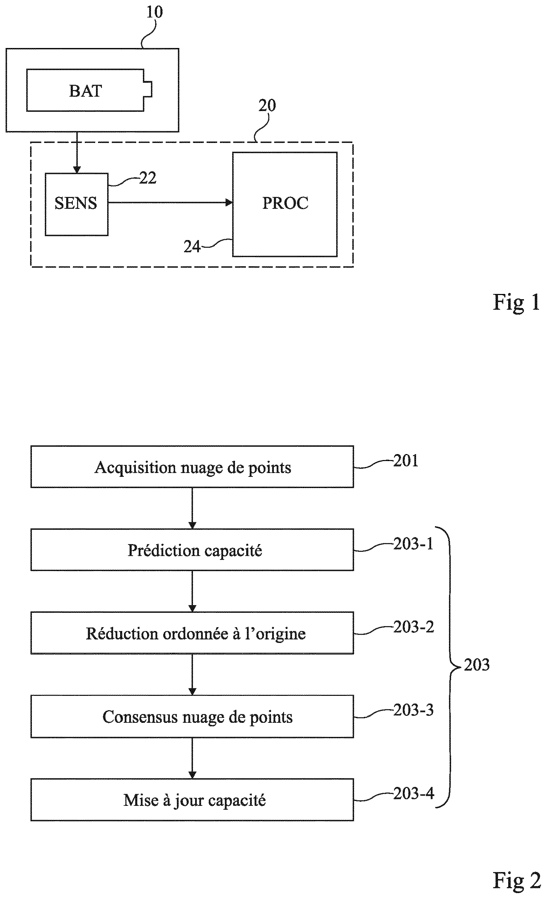

La figure 1 représente de façon schématique un exemple d'un système comportant une batterie électrique 10 (BAT), et un dispositif électronique de gestion 20 adapté à mettre en oeuvre un procédé d'estimation de la capacité C de la batterie 10. La batterie 10 peut être une cellule élémentaire de batterie, ou comprendre plusieurs cellules élémentaires reliées en série et/ou en parallèle. Le dispositif de gestion 20 comprend un dispositif de mesure 22 (SENS) comportant un ou plusieurs capteurs (non détaillés) adaptés à mesurer une ou plusieurs grandeurs physiques de la batterie, par exemple le courant dans la batterie et/ou la tension aux bornes de la batterie et/ou la température de la batterie. Le dispositif de gestion 20 comprend en outre un circuit électronique de traitement 24 (PROC), par exemple un microprocesseur, recevant et traitant les données mesurées par le ou les capteurs du dispositif de mesure 22. Le dispositif de traitement 24 est notamment adapté à estimer la capacité de la batterie 10 à partir des données reçues du dispositif de mesure 22.

Selon un aspect d'un mode de réalisation, le dispositif de gestion 20 est configuré pour :
a) lors d'une phase de recharge et/ou de décharge de la batterie, sélectionner une pluralité de périodes de mesure et, pour chaque période, mesurer la variation de charge ΔQ et estimer la variation d'état de charge ΔSOC de la batterie entre le début et la fin de la période de mesure ; et
b) estimer la capacité de la batterie par filtrage de Kalman à partir des valeurs ΔQ et ΔSOC déterminées à l'étape a). Lors de l'étape b), une étape de consensus sur le nuage de points mesuré est en outre mise en oeuvre pour permettre la fourniture d'une estimation robuste de la capacité.

Les mesures de variation de charge ΔQ et de variation d'état de charge correspondantes ΔSOC de la batterie sont mises en oeuvre lors de l'utilisation normale de la batterie, ce qui rend le procédé transparent pour l'utilisateur.

Les variations de charge ΔQ sont mesurées par intégration du courant injecté ou extrait de la batterie pendant chaque période de mesure. Le courant est par exemple mesuré par un capteur de courant du dispositif de mesure 22. L'intégration du courant entre le début et la fin de la période de mesure peut être mise en oeuvre sous forme numérique par le dispositif de traitement 24.

Les variations d'état de charge ΔSOC sont déterminées au moyen d'un estimateur d'état de charge du dispositif de gestion 20. A titre d'exemple, l'état de charge SOC est estimé au début et à la fin de chaque période de mesure, la variation d'état de charge ΔSOC étant définie comme étant la différence entre la valeur d'état de charge estimée au début de la période de mesure et la valeur d'état de charge estimée à la fin de la période de mesure. L'état de charge est par exemple estimé par le dispositif de traitement 24 à partir de mesures de la tension aux bornes de la batterie, réalisées au moyen d'un capteur de tension du dispositif de mesure 22.

L'ensemble des couples de valeurs (ΔQ, ΔSOC) mesurés constitue un nuage de points utilisé en entrée du filtre de Kalman pour remonter à la capacité de la batterie. Chaque point (ΔQ, ΔSOC) constitue une mesure imprécise et incertaine de la capacité de la batterie, entachée d'une erreur importante liée notamment aux imprécisions du capteur de courant utilisé pour mesurer la variation de charge ΔQ et aux imprécisions de l'estimateur d'état de charge utilisé pour déterminer la variation d'état de charge ΔSOC. Le filtre de Kalman est un estimateur récursif permettant de fournir une estimation fiable de la capacité de la batterie à partir de ces mesures imprécises et incertaines.

La figure 2 représente de façon schématique, sous forme de blocs, un exemple d'un procédé d'estimation de la capacité de la batterie 10 selon un mode de réalisation. Ce procédé est mis en oeuvre par le dispositif électronique de gestion 20 de la batterie.

Le procédé de la figure 2 comprend une étape 201 d'acquisition d'un nuage de points (ΔQ, ΔSOC), correspondant à l'étape de mesure a) susmentionnée. Le nombre M de mesures de couples de valeurs (ΔQ, ΔSOC) réalisées lors de cette étape est par exemple compris entre 10 et 100. Les M périodes de mesure sont sélectionnées par le dispositif de traitement 24 de façon à réaliser un compromis entre la diversité dans le contenu informatif des valeurs mesurées, la précision de l'estimation, et l'adaptabilité. Plus la diversité des points mesurés sera grande - c'est-à-dire plus la dynamique parcourue sera élevée - meilleure sera la précision du filtrage de Kalman. Cependant, si la sélection des points de mesure est effectuée sans a priori particulier sur le profil de courant, sélectionner des valeurs ΔQ et ΔSOC trop faibles implique de travailler sur des points au rapport signal à bruit réduit. Les périodes de mesure courtes et/ou à courant de charge ou de décharge faible sont donc à sélectionner avec parcimonie. A contrario sélectionner des valeurs ΔQ et ΔSOC élevées nécessite des temps de mesure importants, au détriment de l'adaptabilité. Il faut donc faire un compromis entre ces deux contraintes.

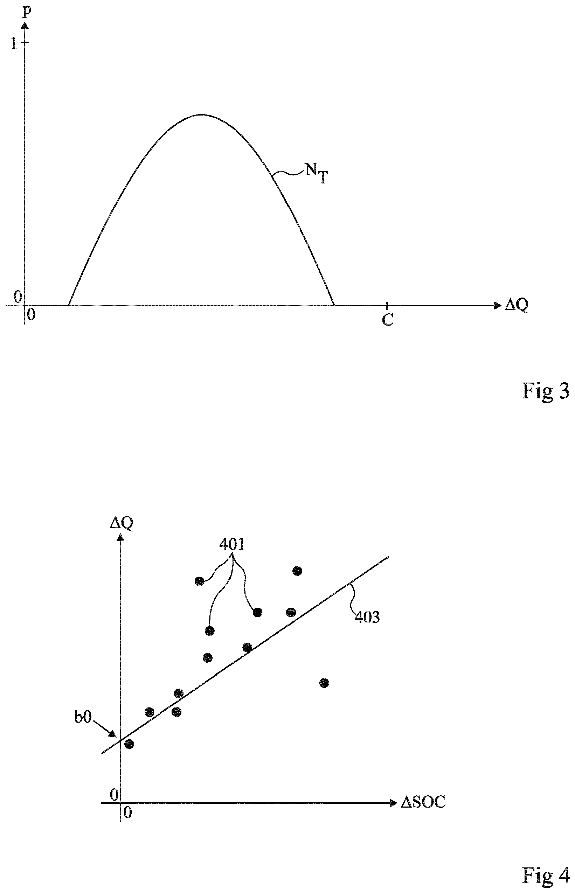

En l'absence d'hypothèse sur le profil du courant de charge/décharge de la batterie, ou si ce courant est stationnaire à l'ordre deux, la courbe de sélection des points de mesure est par exemple une loi normale tronquée N_{T}, par exemple telle qu'illustrée sur la figure 3. Une telle loi de sélection permet d'éviter les valeurs trop petites et trop grandes, et, en moyenne travailler sur des valeurs permettant à l'algorithme d'être suffisamment rapide vis-à-vis de la dynamique du système, c'est-à-dire ici de la capacité de la batterie. A titre d'exemple, la loi de sélection des points de mesure des valeurs ΔQ et ΔSOC est choisie de façon que, en moyenne, l'acquisition des M points du nuage de points nécessite 1 à 10 cycles de charge/décharge de la batterie en utilisation normale.

Si au contraire des hypothèses peuvent être faites sur le profil du courant de charge/décharge de la batterie, il peut être tenu compte de ces hypothèses lors de la sélection des points de mesure.

La figure 3 est un diagramme représentant de façon schématique un exemple de loi N_{T} pouvant être utilisée pour la sélection des M points de mesure lors de l'étape 201. L'axe des abscisses représente la valeur ΔQ de la variation de charge mesurée. L'axe des ordonnées représente la probabilité p de sélection d'un point de mesure de valeur ΔQ lors de l'étape d'acquisition 201.

La figure 4 est un diagramme représentant un exemple de nuage de points 401 mesurés pendant l'étape d'acquisition 201. Chaque point 401 du diagramme correspond à une période de mesure de l'étape d'acquisition 201. L'axe des abscisses représente la variation d'état de charge ΔSOC estimée entre le début et la fin de la période de mesure, et l'axe des ordonnées représente la variation de charge ΔQ mesurée entre le début et la fin de la période de mesure.

Après l'étape 201, le procédé de la figure 2 comprend une étape 203 d'estimation de la capacité de la batterie, au moyen d'un filtre de Kalman que l'on vient mettre à jour à partir des points de mesure acquis à l'étape 201.

Dans cet exemple, l'étape 203 se décompose en quatre sous-étapes 203-1, 203-2, 203-3 et 203-4.

L'étape 203-1 est une étape de prédiction de la capacité de la batterie à partir d'un modèle d'état de l'évolution de la capacité, c'est-à-dire un modèle physique permettant de prédire la capacité de la batterie à l'instant k à partir de sa valeur estimée à l'instant k-1, où k désigne la variable temps discrétisée (l'incrément de temps k-(k-1)=1 correspondant ici à la période entre deux itérations successives des étapes 201 et 203 du procédé de la figure 2). Ce modèle d'état constitue une équation de prédiction du filtre de Kalman. Ce modèle peut être défini en fonction des propriétés électrochimiques de la batterie, ou correspondre à un modèle autorégressif élémentaire.

L'étape 203-2 est une étape de réduction de l'erreur induite, lors de l'étape 201, par les différentes sources de bruit, et notamment par le biais sur le capteur de courant, la nature du courant, et les incertitudes sur les estimations de SOC réalisées. Lors de cette étape, le dispositif de traitement 24 identifie une droite 403 (figure 4) approximant le nuage de points 401 acquis à l'étape 201, et détermine l'ordonnée à l'origine b0 de cette droite. Le terme b0 est représentatif de l'erreur introduite par les différentes sources de bruit lors de l'étape d'acquisition 201 (en l'absence d'erreur, le terme b0 devrait être nul).

Dans cet exemple, l'estimation du terme b0 à l'étape 203-2 est réalisée en appliquant au nuage de points 401 une transformée de Hough à résolution adaptative, par exemple telle que décrite dans l'article intitulé "The Adaptive Hough Transform" (J. Illingworth et al., IEEE transactions on pattern analysis and machine intelligence, vol. PAMI-9, N°5, septembre 1987). La transformée de Hough est un outil de traitement du signal permettant de détecter des droites plongées dans un environnement bruité. Dans le procédé de la figure 2, la transformée de Hough est utilisée uniquement pour déterminer le terme d'erreur b0, c'est-à-dire l'intersection de la droite 403 avec l'axe des ordonnées. En effet, la pente de la droite 403 fournie par la transformée de Hough ne donne pas une estimation suffisamment précise (i.e. répétable) de la capacité de la batterie (la transformée de Hough n'est pas un estimateur récursif). Il faut donc mettre en oeuvre les étapes suivantes 203-3 de consensus sur le nuage de point et 203-4 de mise à jour du filtre de Kalman pour obtenir une estimation fiable de la capacité de la batterie. La transformée de Hough à résolution adaptative permet de rechercher le terme b0 de manière récursive sur une résolution (nombre de points de mesure 401 considérés parmi les M points du nuage de points) qui s'affine au fur et à mesure des itérations. De façon préférentielle, on utilise ici la capacité prédite à l'étape 203-1 ainsi que l'écart type d'erreur d'estimation associé afin de réduire l'espace de recherche de la transformée de Hough et réduire le temps de calcul nécessaire à la recherche du terme b0.

Lors de l'étape 203-3, on sélectionne parmi les M points 401 du nuage de points, les points qui font consensus, c'est-à-dire qui satisfont un critère de consensus prédéfini, aussi appelé critère de réjection des points aberrants. Pour cela, on utilise à l'étape 203-3 une méthode de consensus par sélection aléatoire d'échantillon unique, aussi appelée "one-point RANSAC", telle que décrite dans l'article intitulé "1-Point RANSAC for Extended Kalman Filtering: Application to Real-Time Structure from Motion and Visual Odometry" (J. Civera et al., Journal of Field Robotics 27(5), 609-631, 2010).

Plus particulièrement, dans cet exemple, l'étape 203-3 comprend N_{hyp} itérations successives de la séquence d'étapes suivante, où N_{hyp} est un nombre entier prédéterminé, supérieur ou égal à 2 et inférieur ou égal à M :
203-3a) sélection aléatoire d'un unique point 401 non déjà sélectionné parmi les M points du nuage de points acquis à l'étape 201 ;
203-3b) détermination de la droite passant par le point unique sélectionné à l'étape 203-3a) et ayant pour ordonnée à l'origine la valeur b0 déterminée à l'étape 203-2 ; et
203-3c) détermination des points 401 du nuage de points acquis à l'étape 201 qui satisfont un critère de consensus prédéterminé par rapport à la droite déterminée à l'étape 203-3b).

A titre d'exemple, à l'étape 203-3c), on sélectionne l'ensemble des points 401 du nuage formant, avec l'ordonnée à l'origine b0 déterminée à l'étape 203-2, une droite dont la pente présente, en valeur absolue, une différence de pente par rapport à la droite déterminée à l'étape 203-3b) inférieure à un seuil prédéterminé.

A l'issue des N_{hyp} itérations de la séquence d'étapes 203-3a), 203-3b), 203-3c), on sélectionne l'itération pour laquelle le nombre de points satisfaisant le critère de consensus déterminé à l'étape 203-3c) est le plus élevé. Le jeu de points satisfaisant le critère de consensus lors de cette itération est alors sélectionné.

Lors de l'étape 203-4, la capacité estimée de la batterie est mise à jour, sur la base de la capacité prédite à l'étape 203-1 et d'une mise à jour complète du filtre de Kalman en tenant compte du jeu de points satisfaisant au mieux le critère de consensus, sélectionné à l'étape 203-3.

De préférence, le filtre de Kalman utilisé dans le procédé de la figure 2 est un filtre de Kalman dit sans parfum ou filtre de Kalman unscented, c'est-à-dire à filtre de Kalman basé sur un échantillonnage déterministe, tel que décrit dans l'article intitulé "The Unscented Kalman Filter for Nonlinear Estimation" (Eric A. Wan et al., Oregon Graduate Institute of Science and Technology).

Une fois la capacité de la cellule estimée, cette dernière peut être utilisée par exemple pour réajuster l'estimateur d'état de charge de la batterie. Un test pourra toutefois être réalisé pour vérifier que la nouvelle valeur de capacité améliore bien la précision de l'estimateur d'état de charge, et n'injecter la nouvelle valeur de capacité estimée dans l'estimateur d'état de charge que si cela conduit effectivement à réduire l'erreur d'estimation de l'état de charge. Le critère retenu pour ce test est par exemple le critère que cherche à minimiser l'estimateur d'état de charge. A titre d'exemple, l'estimateur d'état de charge est un filtre de Kalman, et son critère de minimisation est l'erreur sur la tension estimée sachant la capacité. A titre de variante, les hypothèses de capacité peuvent être intégrées directement dans l'estimateur d'état de charge. Pour cela, l'estimateur d'état de charge peut être un filtre de Kalman à mixture.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, des connaissances physiques sur la non-stationnarité du courant dans la batterie peuvent, le cas échéant, être prises en compte pour lisser l'estimation du terme b0 à l'étape 203-2 du procédé de la figure 2.

De plus, si les profils de courant sont connus, et donc si leur stationnarité par morceaux est connue, alors la sélection des périodes de mesure à l'étape 201 peut être adaptée, par exemple de façon à privilégier les périodes sur lesquelles la variation de charge ΔQ mesurée est la plus élevée lorsque le courant moyen est élevé, et privilégier les périodes sur lesquelles la variation de charge ΔQ mesurée est faible lorsque le courant moyen est faible, ceci afin de minimiser l'incertitude sur la valeur b0 fournie par la transformée de Hough.

Par ailleurs, si l'algorithme entre dans une phase de non accrochage, c'est-à-dire s'il n'est pas en mesure de mettre à jour la capacité estimée suffisamment souvent (par rapport à la dynamique d'évolution de la capacité réelle), alors une réinitialisation de l'algorithme peut être mise en oeuvre. A titre d'exemple l'algorithme peut être relancé sur la base d'une valeur de capacité obtenue par une méthode de consensus par sélection aléatoire d'échantillon (RANSAC) utilisée temporairement seule (en dehors du cadre du filtre de Kalman).

En outre, la qualité du consensus peut servir à pondérer dynamiquement l'incertitude posée sur l'équation d'observation du filtre de Kalman. Les mesures de variation de charge ΔQ peuvent en outre être corrélées, ce qui peut être pris en compte dans la matrice de covariance du bruit d'observation du filtre de Kalman.

Si le nombre M de points acquis à l'étape 201 est grand, par exemple supérieur à 50, le nombre d'hypothèses N_{hyp} de la méthode de consensus par sélection aléatoire d'échantillon unique (étape 203-3) peut être réduit en fixant la probabilité de trouver au moins un consensus à une valeur fixe, choisie de façon à respecter la fréquence visée de mise à jour de l'estimation de capacité.

On notera par ailleurs que si le capteur utilisé pour réaliser les mesures présente une précision suffisante, l'étape susmentionnée de détermination de l'ordonnée à l'origine b0 d'une droite approximant le nuage de point 401 acquis à l'étape 201 peut être omise. Dans ce cas, l'ordonnée à l'origine b0 est considérée comme nulle. On notera que même avec cette approximation, les estimations de capacités obtenues par le procédé proposé restent significativement meilleures que les estimations réalisées par les procédés de l'état de la technique.

## Revendications

1. Procédé d'estimation de la capacité d'une batterie électrique (10), mis en oeuvre par un dispositif électronique (20) de gestion de la batterie, comportant les étapes suivantes :
a) lors d'une phase de recharge et/ou de décharge de la batterie, sélectionner une pluralité de périodes de mesure et, pour chaque période, mesurer la variation de charge ΔQ et estimer la variation d'état de charge ΔSOC de la batterie entre le début et la fin de la période de mesure ; et
b) estimer la capacité de la batterie au moyen d'un filtre de Kalman à partir des valeurs ΔQ et ΔSOC déterminées à l'étape a), **caractérisé en ce que**
l'étape b) comprend en outre une étape de détermination ou d'approximation de l'ordonnée à l'origine (b0) d'une droite approximant un nuage de points (401) défini par l'ensemble des couples de valeurs ΔQ, ΔSOC acquis à l'étape a),
l'étape b) comprenant en outre une étape 203-3 de sélection, dans le nuage de points (401), d'un sous-ensemble de points qui satisfont un critère de consensus ou critère de réjection des points aberrant, ledit sous-ensemble de points (401) étant déterminé par une méthode de consensus par sélection aléatoire d'échantillon unique comprenant N_{hyp} itérations successives de la séquence d'étapes suivantes, où N_{hyp} est un entier supérieur ou égal à 2 :
203-3a) sélection aléatoire d'un unique point (401) non déjà sélectionné dans le nuage de points ;
203-3b) détermination d'une droite passant par le point sélectionné à l'étape 203-3a) et par l'ordonnée à l'origine (b0) déterminée ou approximée ; et
203-c) détermination des points (401) du nuage qui satisfont le critère de consensus par rapport à la droite déterminée à l'étape 203-3b),
et l'étape b) comprenant en outre une étape 203-4 de mise à jour du filtre de Kalman à partir du sous-ensemble de points (401) sélectionné à l'étape 203-3.

2. Procédé selon la revendication 1, dans lequel, à l'étape a), les périodes de mesure sont sélectionnées de façon que la densité de probabilité de sélection des valeurs de variation de charge ΔQ suive une loi normale tronquée (N_{T}).

3. Procédé selon la revendication 1 ou 2, dans lequel les étapes a) et b) sont réitérées de façon régulière au cours de l'utilisation de la batterie (10).

4. Procédé selon l'une quelconque des revendications 1 à 3, dans lequel le nombre de périodes de mesure sélectionnées à chaque itération de l'étape a), et par conséquent le nombre de couples de valeurs ΔQ, ΔSOC acquis à chaque itération de l'étape a), est compris entre 10 et 100.

5. Procédé selon l'une quelconque des revendications 1 à 4, dans lequel l'étape b) comprend une étape 203-1 de prédiction de la capacité de la batterie (10) à partir d'un modèle d'état de l'évolution de la capacité, ce modèle constituant une équation de prédiction du filtre de Kalman.

6. Procédé selon l'une quelconque des revendications 1 à 5, dans lequel, à l'étape 203-2, la droite et l'ordonnée à l'origine (b0) sont déterminées en appliquant au nuage de points (401) une transformée de Hough à résolution adaptative.

## Patentansprüche

1. Verfahren zum Schätzen der Kapazität einer elektrischen Batterie (10), das von einer elektronischen Vorrichtung (20) zum Verwalten der Batterie durchgeführt wird, das die folgenden Schritte aufweist:
a) Auswählen einer Vielzahl von Messperioden während einer Lade- und/oder Entladephase der Batterie und, für jede Periode, Messen der Ladungsvariation ΔQ und Schätzen der Variation des Ladezustands ΔSOC der Batterie zwischen dem Beginn und dem Ende der Messperiode; und
b) Schätzen der Kapazität der Batterie mittels eines Kalman-Filters aus den in Schritt a) bestimmten Werten ΔQ und ΔSOC,
**dadurch gekennzeichnet, dass**
Schritt b) ferner einen Schritt des Bestimmens oder Annäherns an die Ordinate am Ursprung (b0) einer geraden Linie aufweist, die eine Punktwolke (401) approximiert, die durch den Satz von in Schritt a) erfassten Wertepaaren ΔQ, ΔSOC definiert ist,
Schritt b) ferner einen Schritt 203-3 zum Auswählen einer Untermenge von Punkten aufweist, und zwar in der Punktwolke (401), die ein Konsenskriterium oder ein Kriterium zum Zurückweisen von Ausreißern erfüllen, wobei die Untermenge von Punkten (401) durch ein Konsensverfahren von zufälliger Einzel-Proben-Auswahl bestimmt wird, das N_{hyp} aufeinanderfolgende Iterationen der Folge von folgenden Schritten aufweist, wobei N_{hyp} eine ganze Zahl größer oder gleich 2 ist, und zwar mit:
203-3a) zufällig Auswählen eines einzelnen Punktes (401), der nicht bereits in der Punktwolke ausgewählt wurde;
203-3b) Bestimmen einer geraden Linie, die durch den in Schritt 203-3a) ausgewählten Punkt und durch die bestimmte oder angenäherte Ordinate am Ursprung (b0) verläuft; und
203-c) Bestimmen der Punkte (401) der Wolke, die das Konsenskriterium in Bezug auf die in Schritt 203-3b) bestimmte Linie erfüllen, und dass
Schritt b) ferner einen Schritt 203-4 zum Aktualisieren des Kalman-Filters aus der in Schritt 203-3 ausgewählten Teilmenge von Punkten (401) aufweist.

2. Verfahren nach Anspruch 1, wobei in Schritt a) die Messperioden so ausgewählt werden, dass die Wahrscheinlichkeitsdichte der Auswahl der Ladungsvariationswerte ΔQ einem abgestumpften Normalgesetz (NT) folgt.

3. Verfahren nach Anspruch 1 oder 2, wobei die Schritte a) und b) während der Nutzung der Batterie (10) regelmäßig wiederholt werden.

4. Verfahren nach einem der Ansprüche 1 bis 3, wobei die Anzahl der bei jeder Iteration von Schritt a) ausgewählten Messperioden und damit die Anzahl der bei jeder Iteration von Schritt a) erfassten Wertepaare ΔQ, ΔSOC zwischen 10 und 100 liegt.

5. Verfahren nach einem der Ansprüche 1 bis 4, wobei Schritt b) einen Schritt 203-1 zum Vorhersagen der Kapazität der Batterie (10) ausgehend von einem Zustandsmodell der Kapazitätsentwicklung aufweist, wobei dieses Modell eine Vorhersagegleichung des Kalman-Filters bildet.

6. Verfahren nach einem der Ansprüche 1 bis 5, wobei in Schritt 203-2 die Linie und die Ordinate am Ursprung (b0) durch Anwendung einer Hough-Transformation mit adaptiver Auflösung auf die Punktwolke (401) bestimmt werden.

## Claims

1. Method for estimating the capacity of an electric battery (10), implemented by an electronic device (20) for managing the battery, comprising the following steps:
a) during a battery charging and/or discharging phase, selecting a plurality of measurement periods and, for each period, measuring the charge variation ΔQ and estimating the variation of state of charge ΔSOC of the battery between the beginning and the end of the measurement period; and
b) estimating the capacity of the battery by means of a Kalman filter from the values ΔQ and ΔSOC determined in step a), **characterized in that** step b) further comprises a step of determining or approaching the ordinate at the origin (b0) of a straight line approximating a cloud of points (401) defined by the set of pairs of values ΔQ, ΔSOC acquired in step a),
step b) further comprising a step 203-3 of selecting, in the cloud of points (401), a subset of points which satisfy a consensus criterion or criterion for rejecting outliers, said subset of points (401) being determined by a consensus method of single-sample random selection comprising N_{hyp} successive iterations of the sequence of following steps, where N_{hyp} is an integer greater than or equal to 2:
203-3a) randomly selecting a single point (401) not already selected in the cloud of points;
203-3b) determining a straight line passing through the point selected in step 203-3a), and through the determined or approached ordinate at the origin (b0); and
203-c) determining the points (401) of the cloud which satisfy the consensus criterion with respect to the line determined in step 203-3b), and
step b) further comprising a step 203-4 of updating the Kalman filter from the subset of points (401) selected in step 203-3.

2. Method according to claim 1, wherein, in step a), the measurement periods are selected so that the probability density of selection of the charge variation values ΔQ follows a truncated normal law (N_{T}).

3. Method according to claim 1 or 2, wherein steps a) and b) are regularly repeated during the use of the battery (10).

4. Method according to any one of claims 1 to 3, wherein the number of measurement periods selected at each iteration of step a), and therefore the number of pairs of values ΔQ, ΔSOC acquired at each iteration of step a), is between 10 and 100.

5. Method according to any one of claims 1 to 4, wherein step b) comprises a step 203-1 of predicting the capacity of the battery (10) from a state model of the evolution of the capacity, this model constituting a prediction equation of the Kalman filter.

6. Method according to any one of claims 1 to 5, wherein, in step 203-2, the line and the ordinate at the origin (b0) are determined by applying to the cloud of points (401) an adaptive resolution Hough transform.
